# EUROPEAN PATENT APPLICATION

(11) **EP 4 174 210 A1**
(43) Date of publication of application: **03.05.2023**
(21) Application number: 21832782.3
(22) Date of filing: 07.06.2021
(51) Int. Cl.: C23C 16/40, C23C 16/448, C23C 16/455, C30B 25/02, C30B 25/14, C30B 29/16, H01L 21/365, H01L 21/368

(54) **PRODUCTION METHOD FOR DOPING MATERIAL SOLUTION FOR FILM FORMATION, PRODUCTION METHOD FOR LAYERED PRODUCT, DOPING MATERIAL SOLUTION FOR FILM FORMATION, AND SEMICONDUCTOR FILM**

(30) Priority: 29.06.2020 JP 2020111066; 27.01.2021 JP 2021010957
(71) Applicant: SHIN-ETSU CHEMICAL CO., LTD., Tokyo 1000005 (JP); Kochi Prefectural Public University Corporation, Kochi-shi, Kochi 780-8515 (JP)
(72) Inventor: HASHIGAMI, Hiroshi, Annaka-shi, Gunma 379-0195 (JP); WATABE, Takenori, Annaka-shi, Gunma 379-0195 (JP); SAKATSUME, Takahiro, Annaka-shi, Gunma 379-0195 (JP); KAWAHARAMURA, Toshiyuki, Kami-shi, Kochi 782-8502 (JP); DANG, Thai Giang, Kami-shi, Kochi 782-8502 (JP); YASUOKA, Tatsuya, Kami-shi, Kochi 782-8502 (JP)
(74) Representative: Sonnenhauser, Thomas Martin
(86) International application number: PCT/JP2021/021469
(87) International publication number: WO 2022/004279

(57) **Abstract**

The present invention is a method for producing a doping raw-material solution for film formation, the method including a step of firstly mixing a solute including a halogen-containing organic dopant compound or a dopant halide with a first solvent, but not with other solvents to prepare a dopant precursor solution separately from a film-forming raw material, where an acidic solvent is used as the first solvent. This provides a method for producing a doping raw-material solution for film formation that enables stable formation of a high-quality thin film having excellent electric characteristics.

## Description

### TECHNICAL FIELD

The present invention relates to: a method for producing a doping raw-material solution for film formation, a method for producing a laminate, a doping raw-material solution for film formation, and a semiconductor film.

### BACKGROUND ART

Mist Chemical Vapor Deposition (Mist CVD. Hereinafter, also referred to as "mist CVD method") has been developed by which crystal is grown on a substrate by using a raw material atomized into a mist form. This method enables production of gallium oxide (α-Ga₂O₃) having a corundum structure. In this method, a raw-material solution obtained by dissolving a gallium compound such as gallium acetylacetonate in an acid such as hydrochloric acid is atomized (hereinafter, also referred to as mist is formed) to generate raw-material fine particles. A gas mixture in which the raw-material fine particles are mixed with a carrier gas is supplied to a surface of a substrate having corundum structure, such as sapphire. The raw-material mist is allowed to react with the substrate, so that a thin film of singleoriented gallium oxide is epitaxially grown thereon.

Additionally, when such a grown film is used for an electronic device, impurity-doping for imparting electric conductivity is necessary. This doping is generally performed such that: a dopant precursor solution with a tetravalent dopant dissolved therein is added to a raw-material solution as mentioned above; or such a dopant precursor solution prepared separately from the raw-material solution is atomized and then mixed therewith in a mist form. Patent Document 1 describes an example in which an aqueous solution is prepared using gallium bromide and tin bromide such that the ratio of amount of substance thereof is 1:0.01; in this event, the raw-material solution containing a 48%hydrobromic acid solution in a volume ratio of 10% is used to dope α-gallium oxide with Sn. Moreover, Patent Document 2 describes an example of Si doping using a solution prepared by adding hydrochloric acid to an aqueous solution in which gallium acetylacetonate and 3-cyanopropyldimethylchlorosilane are mixed. Further, Patent Document 3 describes an example in which a mixture of bromide gallium and germanium oxide with ultrapure water is used as a raw-material solution, the germanium oxide serving as a dopant source.

### CITATION LIST

### PATENT LITERATURE

Patent Document 1: JP 2015-196603 A
Patent Document 2: WO 2018/052097 A1
Patent Document 3: JP 2018-35044 A

### SUMMARY OF INVENTION

### TECHNICAL PROBLEM

However, in the methods described in Patent Documents 1, 2, and 3, the properties of the dopant precursors in the solutions are not stable, problems occur that the grown films are not sufficiently doped, or defects are introduced into the grown films due to the by-product, lowering the electric characteristics of the grown films. Hence, particularly, when a film with large area is formed, there are problems that the grown film has non-uniform electric properties, and the film productivity is considerably low.

The present invention has been made to solve the above problems. An object of the present invention is to provide: a method for producing a doping raw-material solution for film formation that enables stable formation of a high-quality thin film having excellent electric characteristics; and a method for producing a laminate by using this method for producing a doping raw-material solution.

Another object of the present invention is to provide: a doping raw-material solution for film formation that enables stable formation of a high-quality thin film with large area having excellent electric characteristics; a method for producing the doping raw-material solution for film formation; and also a method for producing a laminate by using the doping raw-material solution for film formation.

Still another object of the present invention is to provide a semiconductor film having large area and favorable electric resistivity distribution.

### SOLUTION TO PROBLEM

To achieve the object, the present invention provides a method for producing a doping raw-material solution for film formation, the method comprising
a step of firstly mixing a solute comprising a halogen-containing organic dopant compound or a halide dopant with a first solvent, but not with other solvents, to prepare a dopant precursor solution separately from a film-forming raw material, wherein
an acidic solvent is used as the first solvent.

According to such a method, besides a film-forming raw material, a doping precursor solution is produced by mixing a solute including a halogen-containing organic dopant compound or a halide of a dopant with firstly an acidic solvent, not with other solvents. This enables the chemical state of the dopant precursor to be stable and suitable for doping, and makes it possible to suppress generation of by-products derived from the dopant precursor. Accordingly, a doping raw-material solution for film formation is successfully produced which enables formation of a high-quality laminate. Thus, the inventive method for producing a doping raw-material solution for film formation makes it possible to produce a doping raw-material solution for film formation that enables stable formation of a high-quality thin film having excellent electric characteristics.

In this event, the first solvent to be used preferably has a pH of 3 or less.

In this manner, the dopant precursor can be kept more stably in the state suitable for doping.

In this event, the first solvent to be used preferably comprises hydrochloric acid, hydrobromic acid, hydroiodic acid, nitric acid, sulfuric acid, acetic acid, or formic acid.

In this manner, the formation of dopant-derived by-products can be suppressed more effectively.

In this event, the organic dopant compound to be used is preferably a silane compound.

In this manner, it is possible to produce a doping raw-material solution for film formation that can lead to a laminate having more favorable electric properties.

In this event, the halide to be used preferably contains tin.

In this manner, it is possible to produce a doping raw-material solution for film formation that can lead to a laminate having more favorable electric properties.

In this event, the inventive method may further comprise a step of mixing and thereby diluting the dopant precursor solution with a second solvent.

In this manner, the electric properties of the laminate can be controlled more favorably.

Moreover, the present invention provides a method for producing a doping raw-material solution for film formation, the method comprising
a step of firstly mixing a solute comprising a dopant compound with a first solvent, but not with other solvents, to prepare a dopant precursor solution separately from a film-forming raw material, wherein
an acidic solvent is used as the first solvent.

According to such a method, besides a film-forming raw material, a doping precursor solution is produced by mixing a solute including a dopant compound with firstly an acidic solvent, not the other solvents. This enables the chemical state of the dopant precursor to be stable and suitable for doping, and makes it possible to suppress generation of by-products derived from the dopant precursor. Accordingly, a doping raw-material solution for film formation is successfully produced which enables formation of a high-quality laminate. Thus, the inventive method for producing a doping raw-material solution for film formation makes it possible to produce a doping raw-material solution for film formation that enables stable formation of a high-quality thin film having excellent electric characteristics.

In this event, the first solvent to be used preferably has a pH of 1 or less.

In this manner, the dopant precursor can be kept more stably in the state suitable for doping.

In this event, the first solvent to be used preferably comprises hydrochloric acid, hydrobromic acid, hydroiodic acid, nitric acid, sulfuric acid, acetic acid, or formic acid.

In this manner, the formation of dopant-derived by-products can be suppressed more effectively.

In this event, the dopant compound to be used preferably contains any of silicon, tin, and germanium.

In this manner, it is possible to produce a doping raw-material solution for film formation that can lead to a laminate having more favorable electric properties.

In this event, the inventive method may further comprise a step of mixing and thereby diluting the dopant precursor solution with a second solvent.

In this manner, the electric properties of the laminate can be controlled more favorably.

Further, the present invention provides a method for producing a laminate, comprising steps of:
producing a doping raw-material solution for film formation by any of the inventive methods for producing a doping raw-material solution for film formation;
preparing a film-forming raw material solution containing a film precursor;
heating a substrate;
atomizing the doping raw-material solution for film formation and the film-forming raw material solution; and
forming a film by supplying the heated substrate with the atomized doping raw-material solution for film formation and the atomized film-forming raw material solution by utilizing a carrier gas.

In this manner, the doping raw-material solution for film formation to be used is produced with an acidic solvent, separately from a film-forming raw material, according to the inventive methods for producing a doping raw-material solution for film formation. The use of such doping raw-material solution enables production of a laminate having excellent electric properties. Thus, the inventive method for producing a laminate makes it possible to stably form a laminate including a high-quality thin film having excellent electric characteristics.

Furthermore, the present invention provides a doping raw-material solution for film formation employed in mist CVD, the raw-material solution comprising:
a group IV element and a halogen element, wherein
the raw-material solution has a pH of 0.3 or more and 4 or less.

This doping raw-material solution is capable of uniformly forming a high-quality thin film having excellent electric characteristics even on a substrate with large area.

In this case, the raw-material solution preferably has a pH of 1 or more and 3 or less.

This enables formation of a high-quality thin film having more excellent electric characteristics.

Additionally, in this case, the group IV element is preferably any of silicon, tin, and germanium.

These enable the doping raw-material solution with which doping can be performed with more consistent reproducibility.

In addition, the present invention provides a semiconductor film comprising Ga and a group IV element and having a corundum crystal structure, wherein the semiconductor film has a resistivity distribution of ±25% or less.

This semiconductor film has high quality and high productivity.

In this case, the semiconductor film preferably has an area of 50 cm² or more.

This makes the semiconductor film have higher quality and higher productivity.

Moreover, in this case, the semiconductor film preferably has a thickness of 1 µm or more.

This semiconductor film has better quality, is more suitable for semiconductor device, and further can improve flexibility in the design for semiconductor device.

### ADVANTAGEOUS EFFECTS OF INVENTION

As described above, the inventive methods for producing a doping raw-material solution for film formation make it possible to produce a doping raw-material solution for film formation that enables stable formation of a high-quality thin film having excellent electric characteristics. Consequently, the inventive methods for producing a doping raw-material solution for film formation are capable of producing a high-quality doping raw-material solution that enables stable production of a laminate having excellent electric characteristics.

For example, the use of a dopant raw-material solution produced by the inventive methods for producing a doping raw-material solution for film formation can impart excellent electric conductivity to a metal oxide semiconductor film. As a result, a high-quality metal oxide semiconductor film can be produced.

Moreover, the inventive method for producing a laminate makes it possible to stably form a laminate that includes a high-quality thin film having excellent electric characteristics.

Further, with the inventive doping raw-material solution, a high-quality thin film having excellent electric characteristics can be formed uniformly even on a large area substrate with high reproducibility.

Furthermore, the inventive semiconductor film can have high quality and high productivity. As a result, the inventive semiconductor film is superb and inexpensive.

### BRIEF DESCRIPTION OF DRAWINGS

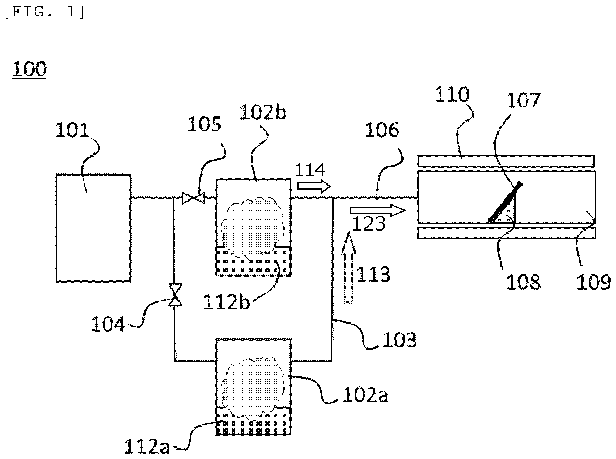

FIG. 1 is a schematic diagram illustrating an example of an apparatus used in a method for producing a laminate according to the present invention.

### DESCRIPTION OF EMBODIMENTS

As noted above, there have been demands for the development of: a doping raw-material solution for film formation that enables stable formation of a high-quality and large-area thin film having excellent electric characteristics; a production method for the doping raw-material solution; and a method for producing a laminate using the doping raw-material solution.

The present inventors have earnestly studied the above problems and consequently conceived the use of solutes including the following dopant compounds as dopant precursors: for example, a halogen-containing organic dopant compound or dopant halide or oxide. The present inventors found that when such a solute is firstly mixed with an acidic first solvent, not with other solvents, to prepare a dopant precursor solution separately from a film-forming raw material, it is possible to make the chemical state of the dopant precursor stable and suitable for doping, and to suppress generation of by-products derived from the dopant precursor. These findings have led to the completion of the present invention.

Specifically, the present invention relates to a method for producing a doping raw-material solution for film formation, the method comprising
a step of firstly mixing a solute comprising a halogen-containing organic dopant compound or a halide dopant with a first solvent, but not with other solvents, to prepare a dopant precursor solution separately from a film-forming raw material, wherein
an acidic solvent is used as the first solvent.

Moreover, the present invention relates to a method for producing a doping raw-material solution for film formation, the method comprising
a step of firstly mixing a solute comprising a dopant compound with a first solvent, but not with other solvents, to prepare a dopant precursor solution separately from a film-forming raw material, wherein
an acidic solvent is used as the first solvent.

Further, the present invention relates to a method for producing a laminate, the method comprising steps of:
producing a doping raw-material solution for film formation by any of the inventive methods for producing a doping raw-material solution for film formation;
preparing a film-forming raw material solution containing a film precursor;
heating a substrate;
atomizing the doping raw-material solution for film formation and the film-forming raw material solution; and
forming a film by supplying the heated substrate with the atomized doping raw-material solution for film formation and the atomized film-forming raw material solution by utilizing a carrier gas.

Furthermore, the present invention relates to a doping raw-material solution for film formation employed in mist CVD, the raw-material solution comprising:
a group IV element and a halogen element, wherein
the raw-material solution has a pH of 0.3 or more and 4 or less.

Furthermore, the present invention relates to a semiconductor film comprising Ga and a group IV element and having a corundum crystal structure, wherein the semiconductor film has a resistivity distribution of ±25% or less.

Hereinafter, the present invention will be described in detail, but the present invention is not limited thereto.

### [Method for Producing Doping Raw-Material Solution for Film Formation]

### (First Embodiment)

A method for producing a doping raw-material solution for film formation according to a first embodiment of the present invention is characterized by including a step of firstly mixing a solute including a halogen-containing organic dopant compound or a halide dopant with a first solvent, but not with other solvents, to prepare a dopant precursor solution separately from a film-forming raw material, where an acidic solvent is used as the first solvent.

First, an acidic first solvent (acid solution) is provided which is a solvent of the dopant precursor solution (hereinafter, also referred to as "dopant solution").

The first solvent used herein preferably includes hydrochloric acid, hydrobromic acid, hydroiodic acid, nitric acid, sulfuric acid, acetic acid, or formic acid. Particularly, it is more preferable to use the first solvent including hydrochloric acid.

Moreover, the first solvent is not particularly limited, as long as it is acidic. The solvent may include water, methanol, ethanol, acetone, etc. Nevertheless, particularly, in a case where a target laminate has poor affinity with carbon, the solvent is preferably in an aqueous solution form.

Further, the first solvent has a pH value, as hydrogen ion concentration index, of preferably 3 or less, more preferably 2 or less. When the first solvent having a pH of 3 or less is used, it is possible to more reliably prevent the dopant precursor from denaturing through chemical reaction to be inactive as a dopant, and also to more reliably prevent the resulting film from having defect. Thus, reductions in the electric properties of the film can be prevented more reliably.

The lower limit of the pH of the first solvent is not particularly limited. For example, the first solvent having a pH of -1.1 or more can be used.

Then, the first solvent is mixed with a solute to prepare a dopant precursor solution. Before the first solvent is mixed with a solute, no other non-acidic solvents are mixed.

The solute to be used includes a halogen-containing organic dopant compound or a halide dopant. The halogen-containing organic dopant compound is not particularly limited, and preferably contains silicon. Chlorodimethylsilane or 3-cyanopropyldimethylchlorosilane is suitably used. Further, the halide dopant is not particularly limited, and preferably contains tin. Anhydrous tin chloride or tin chloride hydrate is suitably used.

Meanwhile, in the present invention, the dopant precursor solution is prepared separately from a film-forming raw material. Hence, the solute does not include a precursor of a target film (film precursor).

The amount of the solute introduced into the first solvent is appropriately adjusted according to a target doping amount in the film, but is preferably, for example, 0.01 mol/L to 0.0000001 mol/L.

After the solute is introduced into the first solvent, the mixture may be stirred. For the stirring, commonly known stirring methods are widely applicable, such as stirring using a stirrer, ultrasound irradiation, and planetary stirring.

The atmosphere under which the series of steps are performed is not limited. The steps are preferably performed in an inert gas, more preferably nitrogen etc.

The dopant precursor solution thus obtained separately and independently from a film-forming raw material may be employed directly for film formation as a doping raw-material solution for film formation, or may be employed after further additional dilution. In other words, the production of the doping raw-material solution for film formation may be completed after the dopant precursor solution is prepared; alternatively, the production may further include a step of mixing and diluting the dopant precursor solution with a second solvent. The second solvent used for the dilution is not particularly limited, and may include water, methanol, ethanol, acetone, etc.

Note that even if an acidic solution is prepared from an aqueous solution obtained after the solute including a halogen-containing organic dopant compound or a halide dopant is introduced into a non-acidic solvent such as pure water, the dopant precursor denatures by chemical reaction and does not act as a dopant, or generates defect in the formed film, so that the film has low electric properties. For the detail, see Comparative Examples to be described later.

### (Second Embodiment)

A method for producing a doping raw-material solution for film formation according to a second embodiment of the present invention is characterized by including a step of firstly mixing a solute including a dopant compound with a first solvent, but not with other solvents, to prepare a dopant precursor solution separately from a film-forming raw material, where an acidic solvent is used as the first solvent.

First, as in the first embodiment, an acidic first solvent (acid solution) is provided which is a solvent of the dopant precursor solution.

The kind of the first solvent used in the second embodiment can be same as those usable in the first embodiment.

In the second embodiment, the first solvent has a pH value, as hydrogen ion concentration index, of preferably 1 or less, more preferably 0.15 or less. When the first solvent having a pH of 1 or less is used, it is possible to more reliably prevent the dopant precursor from denaturing through chemical reaction to be inactive as a dopant, and also to more reliably prevent the resulting film from having defect. Thus, reductions in the electric properties of the film can be prevented more reliably.

In the second embodiment, the lower limit of the pH of the first solvent is not particularly limited. For example, the first solvent having a pH of -1.1 or more can be used.

Then, the first solvent is mixed with a solute to prepare a dopant precursor solution. Before the first solvent is mixed with a solute, no other non-acidic solvents are mixed.

The solute used in the second embodiment is not particularly limited, as long as a dopant compound is included. Particularly suitably usable solutes include a halogen-containing organic dopant compound, a halide dopant, or an oxide dopant. The halogen-containing organic dopant compound and the halide dopant are not particularly limited. For example, those listed in the first embodiment can be employed. Moreover, the oxide dopant is not particularly limited, and preferably contains germanium. Germanium dioxide is suitably used.

Meanwhile, in the second embodiment of the present invention, as in the first embodiment, the dopant precursor solution is prepared separately from a film-forming raw material. Hence, the solute does not include a precursor of a target film (film precursor).

In the second embodiment, the amount of the solute introduced into the first solvent is appropriately adjusted according to a target doping amount in the film, but is preferably, for example, 0.1 mol/L to 0.0000001 mol/L.

After the solute is introduced into the first solvent, the mixture may be stirred as in the first embodiment. Additionally, as in the first embodiment, the atmosphere under which the series of steps are performed is not limited. The steps are preferably performed in an inert gas, more preferably nitrogen etc.

The dopant precursor solution thus obtained separately and independently from a film-forming raw material may be employed directly for film formation as a doping raw-material solution for film formation, or may be employed after further additional dilution.

In this event, the doping raw-material solution preferably has a pH of 0.3 or more and 4 or less, more preferably has a pH of 1 or more and 3 or less. With the pH of 0.3 or more, it is possible to prevent the doping amount into the grown film from decreasing, and to prevent the carrier density from decreasing relative to a target value. Meanwhile, with the pH of 4 or less, it is possible to prevent the electric resistivity distribution from increasing.

That is, the production of the doping raw-material solution for film formation may be completed after the dopant precursor solution is prepared; alternatively, the production may further include a step of mixing and diluting the dopant precursor solution with a second solvent.

In this manner, it is possible to prepare a doping raw-material solution which enables uniform formation of a high-quality thin film having excellent electric characteristics even on a large-area substrate.

As in the first embodiment, the second solvent used for the dilution is not particularly limited, and may include water, methanol, ethanol, acetone, etc.

Note that after the solute including a dopant compound is introduced into a non-acidic solvent such as pure water, even if an acidic solution is prepared from the resulting aqueous solution, the dopant precursor denatures by chemical reaction and does not act as a dopant, or generates defect in the formed film, so that the film has low electric properties. For the detail, see Comparative Examples to be described later.

### [Method for Producing Laminate]

The inventive method for producing a laminate is characterized by including steps of:
producing a doping raw-material solution for film formation by any of the inventive methods for producing a doping raw-material solution for film formation;
preparing a film-forming raw material solution containing a film precursor;
heating a substrate;
atomizing the doping raw-material solution for film formation and the film-forming raw material solution; and
forming a film by supplying the heated substrate with the atomized doping raw-material solution for film formation and the atomized film-forming raw material solution by utilizing a carrier gas.

Hereinbelow, each step will be described.

### [Step of Producing Doping Raw-Material Solution for Film Formation]

This step is a step in which the doping raw-material solution for film formation used in the inventive method for producing a laminate is produced according to any of the inventive methods for producing a doping raw-material solution for film formation. For the detail, see the above descriptions of the inventive method for producing a doping raw-material solution for film formation.

### [Step of Preparing Film-Forming Raw Material Solution]

The film-forming raw material solution can be prepared by mixing a film precursor with a solvent.

The film precursor is not particularly limited, and any compound can be used, as long as it serves as a precursor of a target film.

As the solvent, for example, water or an organic solvent can be used. Moreover, the film-forming raw material solution may contain a small amount of an acid or alkali.

The concentration of the film precursor in the film-forming raw material solution is not particularly limited, and can be appropriately set according to the purpose or specification.

In a case where a gallium oxide film is formed, a gallium precursor solution is prepared as the film-forming raw material solution.

### [Step of Heating Substrate]

The substrate is not particularly limited, as long as a film to be formed can be supported. The material of the substrate may be any known materials, and may be an organic compound or inorganic compound. Examples of the material include, but are not limited to, polysulfone, polyether sulfone, polyphenylene sulfide, polyether ether ketone, polyimide, polyether imide, fluorinated resin; metals, such as iron, aluminum, stainless steel, and gold; silicon, sapphire, quartz, glass, calcium carbonate, gallium oxide, SiC, ZnO, GaN, etc.

In a case where the film is formed by epitaxial growth, a single crystal substrate having desired crystal structure is used.

Regarding the substrate, examples of the shape thereof include plate-like shapes such as flat plate and disk, fibrous, rod-like, columnar, prismatic, cylindrical, helical, spherical, annular shapes, etc. Any of these may be employed. Particularly, in the case of plate-like substrate, the area of a surface where the film is formed is at least 5 cm² or more, preferably 10 cm² or more, particularly preferably 50 cm² or more, in view of productivity. Moreover, the thickness is not particularly limited in the present invention, but is preferably 50 to 2000 um, more preferably 200 to 800 µm.

The heating temperature and heating atmosphere for the substrate are not particularly limited, and can be appropriately selected according components of the doping raw-material solution for film formation and the film-forming raw material solution, as well as the target film composition.

### [Atomizing Step]

In this step, the doping raw-material solution for film formation and the film-forming raw material solution are atomized (also referred to as "mists are formed"). Note that, in the present invention, the term mist refers to fine particles of a liquid dispersed in a gas, includes what is called fog or droplets, and is also referred to as fog or droplets.

The atomizing means is not particularly limited, as long as it is capable of forming fog or droplets. Known means may be employed. In the present invention, atomizing means utilizing ultrasound is preferable.

Depending on the purpose, the doping raw-material solution for film formation to be atomized may be used in mixture with a precursor solution (third solution) which has a different composition. For example, in cases where an oxide containing gallium and aluminum, or the like, is to be formed, an aluminum precursor solution and the doping raw-material solution for film formation may be separately produced and then mixed, followed by atomization of the mixture solution.

Meanwhile, the doping raw-material solution for film formation and the film-forming raw material solution may be separately atomized with different atomizers. Alternatively, the separately produced doping raw-material solution for film formation may be added to the film-forming raw material solution and atomized with the same atomizer.

The fog or droplets obtained by utilizing ultrasound are preferable because the initial speed is zero and these float in air. For example, rather than being blown with a spray, the fog or droplets which float in a space can be conveyed as a gas. Thus, no damage is caused by the collision energy, and this makes the fog or droplets very preferable.

The droplet size is not particularly limited, and the droplets may be of about several mm. The size is preferably 50 um or less, more preferably 0.1 to 10 µm.

### [Film Formation Step]

In this step, the atomized doping raw-material solution for film formation and the atomized film-forming raw material solution are supplied to the heated substrate together with a carrier gas, so that a film is formed.

The carrier gas is not particularly limited. For example, it is possible to suitably use an inert gas such as nitrogen and argon, or a reducing gas such as hydrogen gas and forming gas, besides air, oxygen, and ozone. Regarding the kind, the carrier gas may be one kind, or two or more kinds.

The flow rate of the carrier gas may be appropriately set according to the substrate size or the size of a film-forming chamber. The flow rate can be, for example, about 0.01 to 100 L/min.

Further, the film formation may be performed under any conditions of pressure, reduced pressure, or atmospheric pressure, preferably under atmospheric pressure in view of apparatus cost and productivity.

Next, the inventive method for producing a laminate will be described with reference to FIG. 1 by illustrating a method for producing a laminate including gallium oxide as an example. However, the present invention is not limited thereto.

FIG. 1 illustrates an example of an apparatus used in the inventive method for producing a laminate. In the example of the inventive method for producing a laminate described here, a mist CVD apparatus 100 is used. The mist CVD apparatus 100 include a carrier gas 101, an atomizer 102a, an atomizer 102b, a conveyance pipe 103, a valve 104, a valve 105, a conveyance pipe 106, a susceptor 108, a film-forming chamber 109, and heating means 110.

The structure and so forth of the film-forming chamber 109 are not particularly limited. A metal, such as aluminum and stainless steel, may be used. In a case where a film is formed at a temperature higher than the heating resistant temperature of these metals, quartz or silicon carbide may be used. The heating means 110 for heating a substrate 107 is provided inside or outside the film-forming chamber 109. In addition, the substrate 107 is placed on the susceptor 108 disposed in the film-forming chamber 109.

The atomizer 102a accommodates a gallium precursor solution 112a as the film-forming raw material solution. A solution in which a gallium halide, gallium organic complex, or the like as the film precursor is dissolved in water or an organic solvent is suitably used as the gallium precursor solution 112a in this example. Moreover, these gallium precursor solutions 112a may contain a small amount of an acid or alkali.

In the gallium precursor solution 112a, the gallium concentration is not particularly limited, and can be appropriately set according to the purpose or specification. The gallium concentration is preferably 0.001 mol/L to 2 mol/L, more preferably 0.01 mol/L or more to 0.7 mol/L or less.

The atomizer 102b accommodates a doping raw material 112b including a doping raw-material solution for film formation obtained by the above-described inventive methods for producing a doping raw-material solution for film formation. The doping raw material 112b may be constituted of only the doping raw-material solution for film formation, or may be used in mixture with a precursor solution having different composition depending on the purpose as described above. For example, in the cases where a two-component oxide composed of gallium and aluminum, or the like, is to be formed, an aluminum precursor solution and the doping raw-material solution for film formation which are separately produced may be mixed and used.

Although the description here has been given of the method in which the gallium precursor solution 112a and the doping raw material 112b are accommodated in the different atomizers, the present invention is not limited thereto. It is also possible to accommodate the doping raw material 112b added to the gallium precursor solution 112a in the same atomizer for use as mentioned above. In this case, the doping solution 112b is preferably added to the separately-produced gallium precursor solution 112a for use such that the dopant concentration accounts for 0.0001% to 20%, more preferably 0.001% to 10%, of the Ga concentration in the gallium precursor solution 112a.

There is no particular limitation to atomizing means for the gallium precursor solution 112a and the doping raw material 112b, as long as fog or droplets can be formed as described above. Known means can be employed. In the present invention, atomizing means utilizing ultrasound is preferable.

The carrier gas 101 is mixed with each of the atomized raw materials (precursor solutions) formed in the atomizers 102a and 102b, that is, with the atomized gallium precursor solution (film-forming raw material solution) 112a formed in the atomizer 102a and with the atomized doping raw material 112b (including the atomized doping raw-material solution for film formation) formed in the atomizer 102b. Thereby, a first gas mixture 113 and a second gas mixture 114 are formed, and these are mixed to form a gas mixture 123 and a gas mixture 123 is conveyed to the film-forming chamber 109.

As the carrier gas 101, for example, those described above can be used. Moreover, as the flow rate of the carrier gas 101 also, for example, those described above can be adopted.

In this event, the supply amounts of the gas mixtures 113 and 114 are adjusted according to a target doping level. The dopant supply amount is preferably 0.0001% to 20%, more preferably 0.001% to 10%, of the gallium supply amount.

The gas mixture 123 supplied to the film-forming chamber 109 reacts on the substrate 107 heated by the heating means 110 in the film-forming chamber 109, so that a film is formed.

The example illustrated in FIG. 1 shows a structure in which the atomizer 102b is connected to the film-forming chamber 109 with the conveyance pipe 106, and the conveyance pipe 103 from the atomizer 102a merges with an intermediate portion of the conveyance pipe 10. Nevertheless, the conveyance pipe 103 and the conveyance pipe 106 may be connected to the film-forming chamber 109 independently of each other. The structure is not limited to these. Alternatively, the first gas mixture 113 and the second gas mixture 114 may be introduced into a single buffer tank (unillustrated), and the mist mixed in the buffer tank may be conveyed to the film-forming chamber 109.

Although unillustrated, it is also possible to adjust the mist amount of the gas mixture 123 per unit volume by adding a dilution gas. The flow rate of the dilution gas can be appropriately set, and can be, for example, 0.1 to 10 times as large as that of the carrier gas per minute.

The dilution gas may be supplied, for example, to downstream sides of the atomizers 102a and 102b. Additionally, the dilution gas to be used may be identical to or different from the carrier gas.

The conveyance pipes 103 and 106 are not particularly limited, as long as the conveyance pipes have sufficient stability with respect to the precursor solvent, the temperatures at the interfaces between the reactors and the conveyance pipes, etc. It is possible to widely use pipes made of quartz or common resin, such as polyethylene, polypropylene, vinyl chloride, silicone resin, urethane resin, and fluorinated resin.

### [Doping Raw-Material Solution for Film Formation]

The inventive doping raw-material solution for film formation is a doping raw-material solution for film formation employed in mist CVD, and characterized by: containing a group IV element and a halogen element and having a pH of 0.3 or more and 4 or less.

The doping raw-material solution in this case has a pH of 0.3 or more and 4 or less, more preferably a pH of 1 or more and 3 or less. With the pH of 0.3 or more, it is possible to prevent a decrease in the doping amount into the grown film, and to prevent a decrease in the carrier density relative to a target value. Meanwhile, with the pH of 4 or less, it is possible to prevent an increase in the electric resistivity distribution. Thus, the prepared doping raw-material solution is capable of uniformly forming a high-quality thin film having excellent electric characteristics even on a substrate with large area.

With the group IV element being any of silicon, tin, and germanium, the doping raw-material solution allows doping to be performed with more consistent reproducibility.

The inventive doping raw-material solution for film formation can be produced according to any of the inventive methods for producing a doping raw-material solution for film formation.

### [Semiconductor Film]

Furthermore, the inventive semiconductor film is characterized by: containing Ga and a group IV element and having a corundum crystal structure, where the semiconductor film has a resistivity distribution of ±25% or less.

This semiconductor film has high quality and high productivity.

The smaller the resistivity distribution in the semiconductor film, the more preferable. The value can be ±0% or more.

The semiconductor film preferably has an area of 50 cm² or more.

Thereby, the semiconductor film has higher quality and productivity.

The larger the area of the semiconductor film, the more preferable. Accordingly, the upper limit is not particularly limited, and the area can be, for example, 1000 cm² or less.

Further, in this case, the semiconductor film preferably has a thickness of 1 um or more.

Thereby, the semiconductor film has favorable quality, the film is more suitable for semiconductor devices, and flexibility in the design for semiconductor devices can be further improved.

The upper limit of the film thickness of the semiconductor film is not particularly limited, and the thickness can be, for example, 1000 um or less.

The inventive semiconductor film can be obtained by using a film-forming raw material solution containing Ga and a doping raw-material solution produced according to the inventive method for producing a doping raw-material solution for film formation.

### EXAMPLES

Hereinafter, the present invention will be specifically described by way of Examples and Comparative Examples. However, the present invention is not limited thereto.

### (Example 1)

In Example 1, a mist CVD apparatus as shown in FIG. 1 was used to form an α-gallium oxide film.

As atomizers 102a and 102b, raw-material containers made of borosilicate glass were used, and a film-forming chamber 109 made of quartz was provided. To supply a carrier gas 101, a gas cylinder filled with pure nitrogen gas was used. The gas cylinder and the atomizers 102a and 102b were connected to each other via urethane resin tubes. Further, the atomizers 102a and 102b and the film-forming chamber 109 were connected to each other via conveyance pipes 103 and 106 made of quartz.

Next, raw-material solutions were prepared by the following procedure.

First, in a nitrogen gas-purged atmosphere, dimethylchlorosilane serving as the solute of the dopant precursor solution was put in an aqueous hydrochloric acid solution adjusted to have a pH of 0.5, mixed, and stirred with a stirrer for 30 minutes so as to be dissolved. Then, the resultant was diluted by further adding pure water in an atmosphere to prepare a doping raw-material solution 112b for film formation, which is the dopant precursor solution having a silicon concentration of 0.02 mmol/L. The one raw-material container 102b was filled with the prepared doping raw-material solution 112b for film formation.

Next, in an atmosphere, gallium acetylacetonate as the film precursor was added to a diluted aqueous hydrochloric acid solution prepared by mixing pure water with 1 volume% of hydrochloric acid having a concentration of 35%. The mixture was stirred with a stirrer for 30 minutes to prepare a gallium precursor solution 112a having a Ga concentration of 0.05 mol/L. The other raw-material container 102a was filled with the prepared gallium precursor solution 112a.

Next, a c-plane sapphire substrate 107 with a thickness of 0.6 mm and a diameter of 4 inches was placed on a susceptor 108 made of quartz having been disposed in the film-forming chamber 109, and heated such that the substrate temperature reached 500°C.

Next, with an ultrasonic transducer (frequency: 2.4 MHz), ultrasonic vibration was propagated through water to each of the raw-material solutions 112a and 112b in the respective raw-material containers 102a and 102b to atomize the raw-material solutions 112a and 112b (mists were formed).

Next, to the two raw-material containers 102a and 102b, a nitrogen gas as the carrier gas 101 was added at a flow rate of 3 L/min. Thereby, the film-forming chamber 109 was supplied with a gas mixture 113 of the atomized gallium precursor solution 112a and the nitrogen gas 101 as well as a gas mixture 114 of the atomized doping raw-material solution 112b for film formation and the nitrogen gas 101 for 60 minutes to form a film. Then, supplying the nitrogen gas 101 was stopped, and supplying the gas mixture 123 to the film-forming chamber 109 was stopped.

The series of operations were repeated to prepare ten samples.

In the X-ray diffraction measurement for the crystal layers of all the laminate, peaks appeared at 2θ=40.3°. This verified that the crystal layers of all the laminate samples were α-phase Ga₂O₃.

Subsequently, all the samples were subjected to hole measurement according to a Van der Pauw method to evaluate the carrier density and carrier mobility.

### (Example 2)

Films were formed as in Example 1, except that the aqueous hydrochloric acid solution used to dissolve dimethylchlorosilane had a pH of 2.0. Ten samples were prepared.

In the X-ray diffraction measurement for the crystal layers of all the laminate, peaks appeared at 2θ=40.3°. This verified that the crystal layers of all the laminate samples were α-phase Ga₂O₃.

Then, the films of all the samples were evaluated as in Example 1.

### (Example 3)

Films were formed as in Example 1, except that 3-cyanopropyldimethylchlorosilane was used as the solute of the dopant precursor solution. Ten samples were prepared.

In the X-ray diffraction measurement for the crystal layers of all the laminate, peaks appeared at 2θ=40.3°. This verified that the crystal layers of all the laminate samples were α-phase Ga₂O₃.

Then, the films of all the samples were evaluated as in Example 1.

### (Example 4)

Films were formed as in Example 1, except that tin (II) chloride dihydrate was used to prepare a solution with a tin concentration of 0.02 mmol/L as the dopant precursor solution. Ten samples were prepared. In Example 4, an aqueous hydrochloric acid solution prepared to have a pH of 0.5 was used as the solvent used to dissolve tin (II) chloride dihydrate.

In the X-ray diffraction measurement for the crystal layers of all the laminate, peaks appeared at 2θ=40.3°. This verified that the crystal layers of all the laminate samples were α-phase Ga₂O₃.

Then, the films of all the samples were evaluated as in Example 1.

### (Comparative Example 1)

Films were formed as in Example 1, except that after dimethylchlorosilane was put in pure water, hydrochloric acid was further added to adjust the pH to 0.5 and to prepare the dopant precursor solution. Ten samples were prepared.

In the X-ray diffraction measurement for the crystal layers of all the laminate, peaks appeared at 2θ=40.3°. This verified that the crystal layers of all the laminate samples were α-phase Ga₂O₃.

Then, the films of all the samples were evaluated as in Example 1.

### (Comparative Example 2)

Films were formed as in Example 3, except that after 3-cyanopropyldimethylchlorosilane was put in pure water, hydrochloric acid was further added to adjust the pH to 0.5 and to prepare the dopant precursor solution. Ten samples were prepared.

In the X-ray diffraction measurement for the crystal layers of all the laminate, peaks appeared at 2θ=40.3°. This verified that the crystal layers of all the laminate samples were α-phase Ga₂O₃.

Then, the films of all the samples were evaluated as in Example 1.

### (Comparative Example 3)

Films were formed as in Example 4, except that after tin (II) chloride dihydrate was put in pure water, hydrochloric acid was further added to adjust the pH to 0.5 and to prepare the dopant precursor solution. Ten samples were prepared.

In the X-ray diffraction measurement for the crystal layers of all the laminate, peaks appeared at 2θ=40.3°. This verified that the crystal layers of all the laminate samples were α-phase Ga₂O₃.

Then, the films of all the samples were evaluated as in Example 1.

Table 1 below shows average values of the ten samples regarding the carrier density and carrier mobility of the films obtained in each of Examples 1, 2, 3 and 4 as well as Comparative Examples 1, 2 and 3.

**[Table 1]**

| | Carrier density [cm⁻³] | Mobility [cm²/ (V·s)] |
|---|---|---|
| Example 1 | 7.13×10¹⁸ | 17.8 |
| Example 2 | 6.76×10¹⁸ | 18.3 |
| Example 3 | 6.97×10¹⁸ | 18.0 |
| Example 4 | 7.02×10¹⁸ | 17.5 |
| Comparative Example 1 | 2.11×10¹⁸ | 2.5 |
| Comparative Example 2 | 3.45×10¹⁸ | 1.8 |
| Comparative Example 3 | 2.88×10¹⁸ | 2.0 |

As shown by the results of Examples 1, 2, 3 and 4 shown in Table 1, the doping raw-material solutions for film formation produced by the inventive method for producing a doping raw-material solution for film formation are excellent and enable stable doping and preparation of high-quality films with high carrier mobility. In contrast, the carrier density was low and the mobility was greatly lower in the films obtained in Comparative Examples 1, 2 and 3 using the doping raw-material solutions produced by the method for producing a doping raw-material solution according to the conventional technique, that is, a method in which the dopant precursor is firstly dissolved in pure water.

### (Example 5)

In Example 5, a mist CVD apparatus as shown in FIG. 1 was used to form an α-gallium oxide film.

The mist CVD apparatus was provided as in Example 1.

Next, raw-material solutions were prepared by the following procedure.

First, in a nitrogen gas-purged atmosphere, dimethylchlorosilane serving as the solute of the dopant precursor solution was put in an aqueous hydrochloric acid solution adjusted to have a pH of 0.1, mixed, and stirred with a stirrer for 30 minutes so as to be dissolved. Then, the resultant was diluted by further adding pure water in an atmosphere so that the pH was adjusted to 2.0. Thus, a doping raw-material solution 112b for film formation, which is the dopant precursor solution having a silicon concentration of 0.02 mmol/L, is prepared. The one raw-material container 102b was filled with the prepared doping raw-material solution 112b for film formation.

Next, according to the same procedure as in Example 1, a gallium precursor solution 112a having a Ga concentration of 0.05 mol/L was prepared. The other raw-material container 102a was filled with the prepared gallium precursor solution 112a.

Next, a c-plane sapphire substrate 107 with a thickness of 0.6 mm and a diameter of 4 inches was placed on a susceptor 108 made of quartz having been disposed in the film-forming chamber 109, and heated such that the substrate temperature reached 500°C.

Next, with an ultrasonic transducer (frequency: 2.4 MHz), ultrasonic vibration was propagated through water to each of the raw-material solutions 112a and 112b in the respective raw-material containers 102a and 102b to atomize the raw-material solutions 112a and 112b (mists were formed).

Next, to the two raw-material containers 102a and 102b, a nitrogen gas as the carrier gas 101 was added at a flow rate of 3 L/min. Thereby, the film-forming chamber 109 was supplied with a gas mixture 113 of the atomized gallium precursor solution 112a and the nitrogen gas101 as well as a gas mixture 114 of the atomized doping raw-material solution 112b for film formation and the nitrogen gas 101 for 60 minutes to form a film. Then, supplying the nitrogen gas 101 was stopped, and supplying the gas mixture 123 to the film-forming chamber 109 was stopped. Thus, a laminate was prepared.

In the X-ray diffraction measurement for the crystal layers of all the laminate, a peak appeared at 2θ=40.3°. This verified that the crystal layer of the prepared laminate was α-phase Ga₂O₃.

Then, the film sample was evaluated as in Example 1.

### (Example 6)

A film was formed as in Example 5, except that the pH of the doping raw-material solution 112b for film formation was set to 0.3.

In the X-ray diffraction measurement for the crystal layers of all the laminate, a peak appeared at 2θ=40.3°. This verified that the crystal layer of the laminate sample was α-phase Ga₂O₃.

Then, the film sample was evaluated as in Example 1.

### (Example 7)

A film was formed as in Example 5, except that the pH of the doping raw-material solution 112b for film formation was set to 4.0.

In the X-ray diffraction measurement for the crystal layers of all the laminate, a peak appeared at 2θ=40.3°. This verified that the crystal layer of the laminate sample was α-phase Ga₂O₃.

Then, the film sample was evaluated as in Example 1.

### (Comparative Example 4)

A film was formed as in Example 5, except that after dimethylchlorosilane was put in pure water, hydrochloric acid was further added to adjust the pH to 0.1 and to prepare the dopant precursor solution, which was diluted with pure water to adjust the pH to 2.

In the X-ray diffraction measurement for the crystal layers of all the laminate, a peak appeared at 2θ=40.3°. This verified that the crystal layer of the laminate sample was α-phase Ga₂O₃.

Then, the film sample was evaluated as in Example 1.

### (Example 8)

A film was formed as in Example 5, except that a solution having a silicon concentration of 0.02 mmol/L was prepared as the dopant precursor solution by dissolving 3-cyanopropyldimethylchlorosilane in an aqueous hydrochloric acid solution prepared to have a pH of 0.1.

In the X-ray diffraction measurement for the crystal layers of all the laminate, a peak appeared at 2θ=40.3°. This verified that the crystal layer of the laminate sample was α-phase Ga₂O₃.

Then, the film sample was evaluated as in Example 1.

### (Example 9)

A film was formed as in Example 5, except that a solution having a tin concentration of 0.02 mmol/L was prepared as the dopant precursor solution by dissolving tin (II) chloride dihydrate in an aqueous hydrochloric acid solution prepared to have a pH of 0.1.

In the X-ray diffraction measurement for the crystal layers of all the laminate, a peak appeared at 2θ=40.3°. This verified that the crystal layer of the laminate sample was α-phase Ga₂O₃.

Then, the film sample was evaluated as in Example 1.

### (Example 10)

A film was formed as in Example 5, except that a solution having a germanium concentration of 0.02 mmol/L was prepared as the dopant precursor solution by dissolving germanium oxide in an aqueous hydrochloric acid solution prepared to have a pH of 0.1.

In the X-ray diffraction measurement for the crystal layers of all the laminate, a peak appeared at 2θ=40.3°. This verified that the crystal layer of the laminate sample was α-phase Ga₂O₃.

Then, the film sample was evaluated as in Example 1.

Table 2 below shows the resistivity distribution, carrier density, and carrier mobility of the films obtained in Examples 5, 6, 7, 8, 9 and 10 as well as Comparative Example 4.

**[Table 2]**

| | Resistivity distribution [±%] | Carrier density [cm⁻³] | Mobility [cm²/ (V·s)] |
|---|---|---|---|
| Example 5 | 10.6 | 7.13×10¹⁸ | 10.3 |
| Example 6 | 15.6 | 5.76×10¹⁸ | 9.8 |
| Example 7 | 23.3 | 6.97×10¹⁸ | 9.5 |
| Comparative Example 4 | 1189.0 | 1.10×10¹⁸ | 0.5 |
| Example 8 | 9.8 | 7.63×10¹⁸ | 9.7 |
| Example 9 | 10.5 | 6.99×10¹⁸ | 10.0 |
| Example 10 | 10.1 | 7.02×10¹⁸ | 9.4 |

As shown in the results of Examples 5, 6, 7, 8, 9 and 10 shown in Table 2, the doping raw-material solutions for film formation produced by the inventive method for producing a doping raw-material solution for film formation are excellent and enable stable doping and preparation of high-quality films with favorable resistivity distribution and high carrier mobility. In contrast, the resistivity distribution was wide, the carrier density was low, and the mobility was greatly lower in the film obtained in Comparative Example 4 using the doping raw-material solution produced by the method for producing a doping raw-material solution according to the conventional technique, that is, a method in which the dopant precursor is dissolved in pure water.

It should be noted that the present invention is not limited to the above-described embodiments. The embodiments are just examples, and any embodiments that substantially have the same feature and demonstrate the same functions and effects as those in the technical concept disclosed in claims of the present invention are included in the technical scope of the present invention.

## Claims

1. A method for producing a doping raw-material solution for film formation, the method comprising
a step of firstly mixing a solute comprising a halogen-containing organic dopant compound or a halide dopant with a first solvent, but not with other solvents, to prepare a dopant precursor solution separately from a film-forming raw material, wherein
an acidic solvent is used as the first solvent.

2. The method for producing a doping raw-material solution for film formation according to claim 1,
wherein the first solvent to be used has a pH of 3 or less.

3. The method for producing a doping raw-material solution for film formation according to claim 1 or 2, wherein the first solvent to be used comprises hydrochloric acid, hydrobromic acid, hydroiodic acid, nitric acid, sulfuric acid, acetic acid, or formic acid.

4. The method for producing a doping raw-material solution for film formation according to any one of claims 1 to 3, wherein the organic dopant compound to be used is a silane compound.

5. The method for producing a doping raw-material solution for film formation according to any one of claims 1 to 3, wherein the halide to be used contains tin.

6. The method for producing a doping raw-material solution for film formation according to any one of claims 1 to 5, further comprising a step of mixing and thereby diluting the dopant precursor solution with a second solvent.

7. A method for producing a laminate, comprising steps of:
producing a doping raw-material solution for film formation by the method for producing a doping raw-material solution for film formation according to any one of claims 1 to 6;
preparing a film-forming raw material solution containing a film precursor;
heating a substrate;
atomizing the doping raw-material solution for film formation and the film-forming raw material solution; and
forming a film by supplying the heated substrate with the atomized doping raw-material solution for film formation and the atomized film-forming raw material solution by utilizing a carrier gas.

8. A method for producing a doping raw-material solution for film formation, the method comprising
a step of firstly mixing a solute comprising a dopant compound with a first solvent, but not with other solvents, to prepare a dopant precursor solution separately from a film-forming raw material, wherein
an acidic solvent is used as the first solvent.

9. The method for producing a doping raw-material solution for film formation according to claim 8, wherein the first solvent to be used has a pH of 1 or less.

10. The method for producing a doping raw-material solution for film formation according to claim 8 or 9, wherein the first solvent to be used comprises hydrochloric acid, hydrobromic acid, hydroiodic acid, nitric acid, sulfuric acid, acetic acid, or formic acid.

11. The method for producing a doping raw-material solution for film formation according to any one of claims 8 to 10, wherein the dopant compound to be used contains any of silicon, tin, and germanium.

12. The method for producing a doping raw-material solution for film formation according to any one of claims 8 to 11, further comprising a step of mixing and thereby diluting the dopant precursor solution with a second solvent.

13. A method for producing a laminate, comprising steps of:
producing a doping raw-material solution for film formation by the method for producing a doping raw-material solution for film formation according to any one of claims 8 to 12;
preparing a film-forming raw material solution containing a film precursor;
heating a substrate;
atomizing the doping raw-material solution for film formation and the film-forming raw material solution; and
forming a film by supplying the heated substrate with the atomized doping raw-material solution for film formation and the atomized film-forming raw material solution by utilizing a carrier gas.

14. A doping raw-material solution for film formation employed in mist CVD, the raw-material solution comprising:
a group IV element and a halogen element, wherein
the raw-material solution has a pH of 0.3 or more and 4 or less.

15. The doping raw-material solution for film formation according to claim 14, wherein the raw-material solution has a pH of 1 or more and 3 or less.

16. The doping raw-material solution according to claim 14 or 15, wherein the group IV element is any of silicon, tin, and germanium.

17. A semiconductor film comprising Ga and a group IV element and having a corundum crystal structure, wherein the semiconductor film has a resistivity distribution of ±25% or less.

18. The semiconductor film according to claim 17, wherein the semiconductor film has an area of 50 cm² or more.

19. The semiconductor film according to claim 17 or 18, wherein the semiconductor film has a thickness of 1 um or more.
